# EUROPEAN PATENT APPLICATION

(11) **EP 0 600 501 A1**
(43) Date of publication of application: **08.06.1994**
(21) Application number: 93119473.2
(22) Date of filing: 02.12.1993
(51) Int. Cl.: H01L 23/31, H01L 23/433, H01L 21/56

(54) **Resin molded semiconductor device**

(30) Priority: 03.12.1992 JP 323887/92
(71) Applicant: NEC CORPORATION, Tokyo (JP)
(72) Inventor: Tateishi, Yuichi, Minato-ku, Tokyo (JP)
(74) Representative: Glawe, Delfs, Moll & Partner

(57) **Abstract**

A film carrier type semiconductor element (1) includes a film (12), internal leads (11-1, 11-2, ..., 11'-1, 11'-2, ...) adhered thereto, and a semiconductor chip (13) contacted to inner portions of the internal leads. A lead frame (2) includes an island (23') and external leads (21-1, 21-2, ...). The film carrier semiconductor element is assembled in the lead frame by contacting the semiconductor chip to the island and by connecting outer portions of the internal leads to the external leads. An enveloper (5', 5'') made of resin encapsulates the film carrier type semiconductor element and a part of the external leads. The thickness of resin from the island to a rear face of the enveloper (D1') is substantially the same as that from the film to a front face of the enveloper (D2').

## Description

### BACKGROUND OF THE INVENTION

### Field of the Invention

The present invention relates to a resin molded semiconductor device for a combination of a film carrier type semiconductor element and a lead frame.

### Description of the Related Art

Generally, a film carrier type semiconductor element includes a film having a plurality of internal leads thereon, and a semiconductor chip contacted to inner portions of the internal leads. On the one hand, a lead frame includes an island for supporting the semiconductor chip, and a plurality of external leads. The film carrier type semiconductor element is assembled into the lead frame by contacting the semiconductor chip to the island and by connecting the outer portions of the internal leads to the external leads, to complete a semiconductor assembly.

The above-mentioned semiconductor assembly is sandwiched by two metal molds, so that the semiconductor assembly is located in a cavity between the metal molds. Then, hot resin is injected into the cavity, and the injected resin is cooled and hardened by the metal molds, to thereby form an enveloper made of resin for the semiconductor assembly. Thus, a resin molded semiconductor is completed, which will be explained later in more detail.

In the above-mentioned resin molded semiconductor device, however, since a lower cavity below the island is remarkably larger than an upper cavity above the film, so that the amount of resin injected into the lower cavity is remarkably larger than that injected into the upper cavity at an initial stage of injection of resin, the island may be moved up by the pressure of the resin injected into the lower cavity. Simultaneously, since the island is wider than the film, so that resin is hardly injected into a middle cavity between the film and the island, the film may be moved down by the pressure of resin injected into the upper cavity.

When the island is moved up, and/or, when the film is moved down, an edge of the semiconductor chip may be in contact with an inner portion of one of the internal leads, thus inviting a short circuit. Also, the injected resin may be cracked, thus deteriorating the reliability of the resin molded semiconductor device.

### SUMMARY OF THE INVENTION

It is an object of the present invention to provide a resin molded semiconductor device which can avoid a short-circuit and enhance the reliability of the device.

According to the present invention, a film carrier type semiconductor element includes a film, internal leads adhered thereto, and a semiconductor chip contacted to inner portions of the internal leads. A lead frame includes an island and external leads. The film carrier semiconductor element is assembled in the lead frame by contacting the semiconductor chip to the island and by connecting outer portions of the internal leads to the external leads. An enveloper made of resin encapusulates the film carrier type semiconductor element and a part of the external leads. The thickness of resin from the island to a rear face of the enveloper is substantially the same as that from the film to a front face of the enveloper. Thus, the pressure of resin below the island is reduced, and as a result, the amount of moving-up of the island is reduced.

Also, according to the present invention, the island is narrower than the film. Thus, the pressure of resin between the film and the island is increased, and as a result, the amount of moving-down of the film is reduced.

### BRIEF DESCRIPTION OF THE DRAWINGS

The present invention will be more clearly understood from the description as set forth below, in comparison with the prior art, with reference to the accompanying drawings, wherein:
Figs. 1A and 2A are plan views illustrating a prior art film carrier type semiconductor element;
Figs. 1B and 2B are cross-sectional views taken along the line I - I of Fig. 1A and the line II - II of Fig. 2A, respectively;
Fig. 3A is a plan view illustrating a prior art lead frame;
Fig. 3B is a cross-sectional view taken along the line III - III of Fig. 3A;
Fig. 4A is a plan view illustrating a prior art semiconductor device formed by the film carrier type semiconductor element of Fig. 2A and the lead frame of Fig. 3A;
Fig. 4B is a cross-sectional view taken along the line IV - IV of Fig. 4A;
Fig. 5 is a cross-sectional view of the semiconductor device of Figs. 4A and 4B sandwiched by metal molds;
Fig. 6A is a plan view of the semiconductor device of Figs. 4A and 4B which is resin molded;
Fig. 6B is a cross-sectional view taken along the line VI - VI of Fig. 6A;
Fig. 7 is a cross-sectional view illustrating a resin injecting state of the semiconductor device of Fig. 5;
Fig. 8 is a partial enlargement of Fig. 7;
Fig. 9A is a plan view illustrating a lead frame according to the present invention;
Fig. 9B is a cross-sectional view taken along the line IX - IX of Figs. 9A;
Fig. 10A is a plan view illustrating a first embodiment of the semiconductor device according to the present invention;
Fig. 10B is a cross-sectional view taken along the line X - X of Fig. 10A;
Fig. 11 is a cross-sectional view of the semiconductor device of Fig. 10B sandwiched by metal molds;
Fig. 12 is a cross-sectional view of the semiconductor device of Figs. 10A and 10B which is resin molded;
Fig. 13 is a cross-sectional view illustrating a resin injecting state of the semiconductor device of Fig. 11;
Fig. 14A is a plan view illustrating a second embodiment of the semiconductor device according to the present invention;
Fig. 14B is a cross-sectional view taken along the line XIV - XIV of Fig. 14A;
Fig. 15 is a cross-sectional view of the semiconductor device of Fig. 14B sandwiched by metal molds;
Fig. 16 is a cross-sectional view of the semiconductor device of Figs. 14A and 14B which is resin molded;
Fig. 17 is a cross-sectional view illustrating a resin injecting state of the semiconductor device of Fig. 15; and
Fig. 18 is a graph showing a relationship between the resin thickness ratio and the amount of moving-up of the island.

### DESCRIPTION OF THE PREFERRED EMBODIMENTS

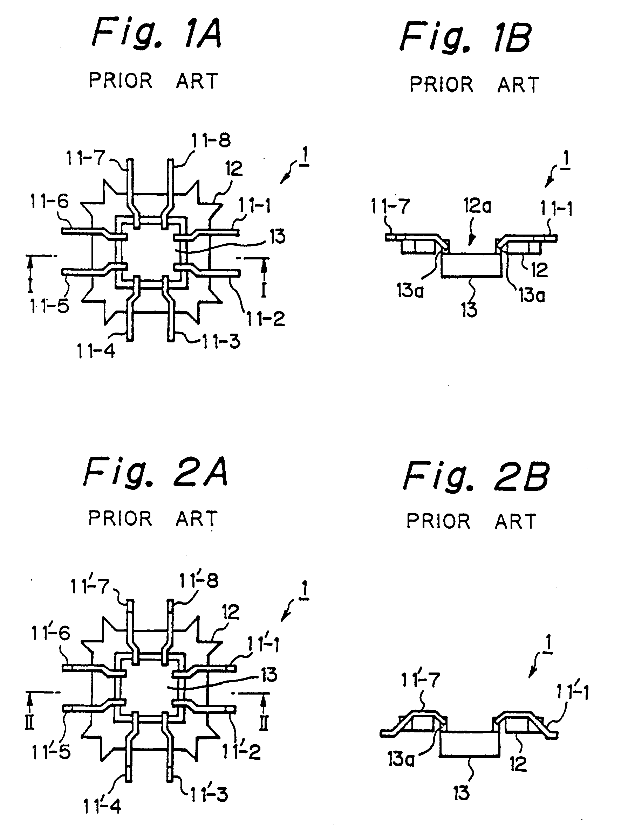

Before the description of embodiments of the present invention, the manufacturing steps of a prior art resin molded semiconductor device will be explained with reference to Figs. 1A, 1B, 2A, 2B, 3A, 3B, 4A, 4B, 5, 6A, 6B, 7 and 8.

First, as illustrated in Fig. 1A and Fig. 1B, which is a cross-sectional view taken along the line I - I of Fig. 1A, a film carrier type semiconductor element 1 is prepared. The film carrier type semiconductor element 1 is manufactured by adhering a lead pattern of internal leads 11-1, 11-2, ..., and 11-8 made of copper foil or the like, to an insulating film carrier tape (not shown) made of polyimid or the like and which includes a film 12 as a part thereof. Then, a semiconductor chip 13 is mounted on the film carrier tape via a device hole 12a, and metal protrusions, i.e., bumps 13a of the semiconductor chip 13 are bonded to inner portions of the internal leads 11-1, 11-2, ..., and 11-8 using a thermal pressure method or a eutectic method. Then, the film carrier tape and the outer portions internal leads 11-1, 11-2, ..., and 11-8 are cut by a cut mold, to thereby complete the film carrier type semiconductor element 1 as illustrated in Figs. 1A and 1B.

Next, as illustrated in Fig. 2A and Fig. 2B, which is a cross-sectional view taken along the II - II of Fig. 2A, the outer portions of the internal leads 11-1, 11-2, ..., and 11-8 are bent down by using a pressing tool (not shown).

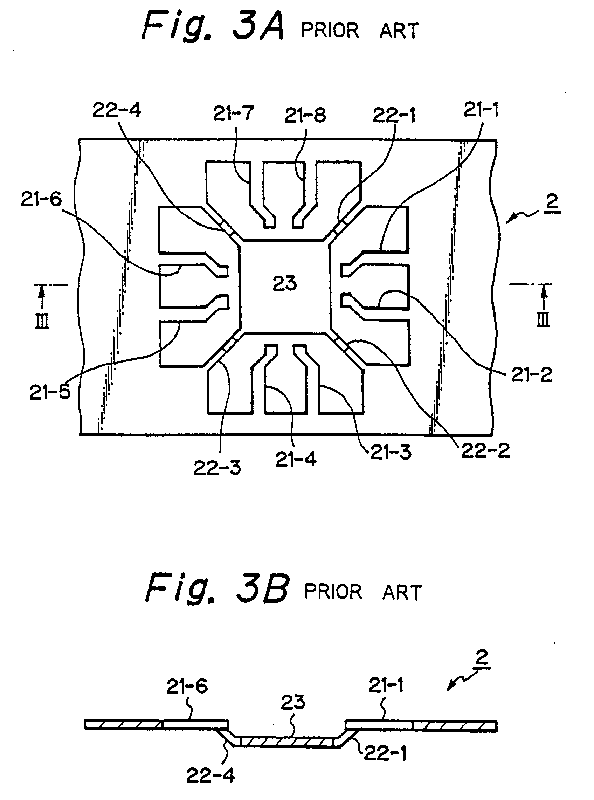

On the one hand, as illustrated in Fig. 3A and Fig. 3B, which is a cross-sectional view taken along the line III - III of Fig. 3A, a lead frame 2 made of metal such as copper is prepared. The lead frame 2 includes external leads 21-1, 21-2, ..., and 21-8, four suspenders 22-1, 22-2, 22-3 and 22-4, and an island 23 suspended by the suspenders 22-1, 22-2, 22-3 and 22-4.

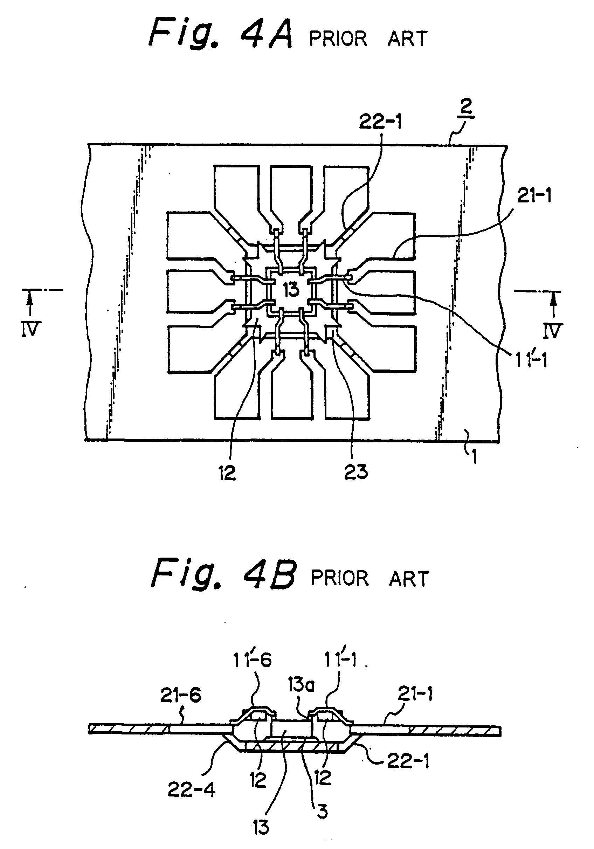

Next, as illustrated in Fig. 4A and Fig. 4B which is a cross-sectional view taken along the line IV - IV of Fig. 4A, the film carrier type semiconductor element 1 of Figs. 2A and 2B is mounted on the lead frame of Figs. 3A and 3B, thus obtaining a semiconductor assembly. In this case, the outer portions of the internal leads 11'-1, 11'-2, ..., and 11'-8 are bonded to the inner portions of the external leads 21-1, 21-2, ..., and 21-8, respectively, by using a thermal pressure method or a eutectic method. Also, the semiconductor chip 13 is bonded to the island 23 by an adhesive member 3 which is hardened by a heat treatment.

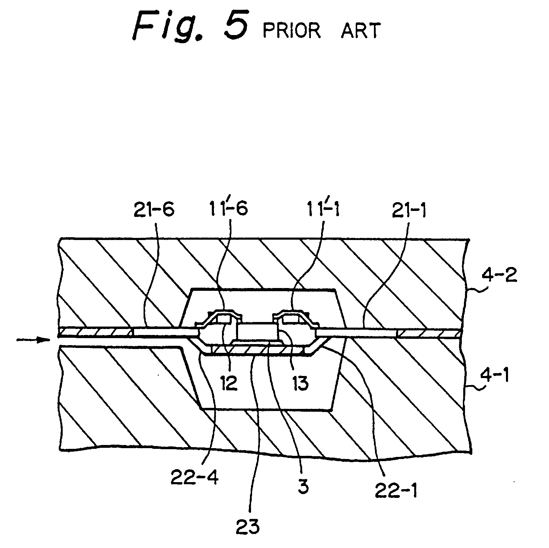

Then, as illustrated in Fig. 5, the semiconductor device of Figs. 4A and 4B is sandwiched by a lower metal mold 4-1 and 4-2. Then, hot resin is injected into a cavity between the lower metal mold 4-1 and the upper metal mold 4-2, as indicated in the figure by an arrow.

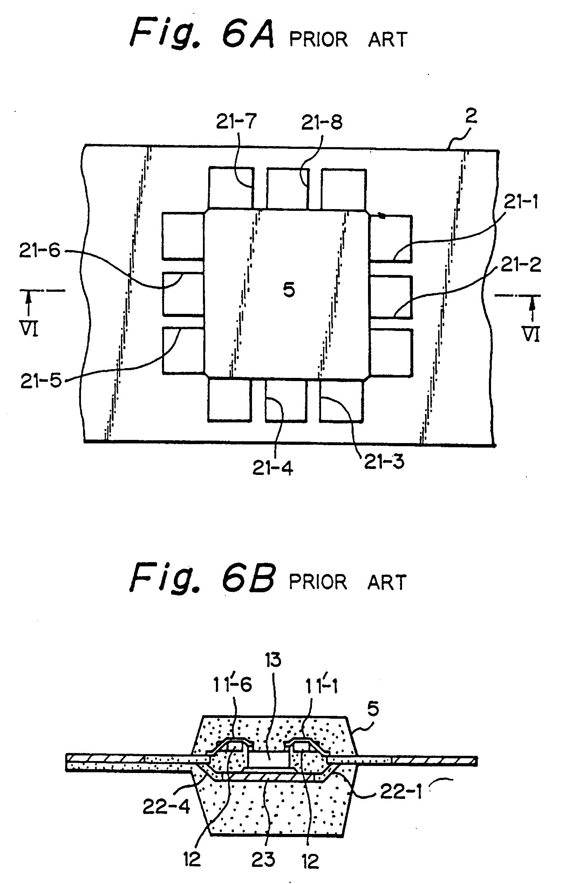

Next, as illustrated in Fig. 6A and Fig. 6B which is a cross-sectional view taken along the line VI - VI of Fig. 6A, the lower metal mold 4-1 and the upper metal mold 4-2 are removed, and as a result, an enveloper 5 made of resin encapsulates the semiconductor assembly. In this state, probes are in contact with the external leads 21-1, 21-2, ..., and 21-8, to thereby carry out a test, thus completing a resin molded semiconductor device.

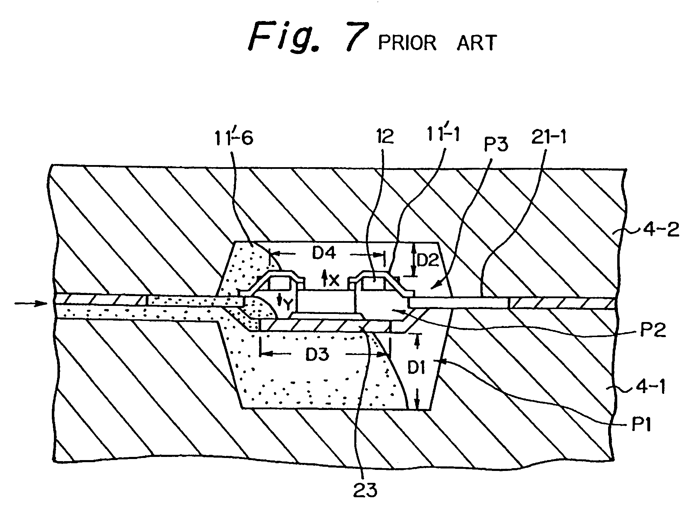

In Fig. 7, which explains a problem caused by the prior art resin molded semiconductor device, a cavity between the lower metal mold 4-1 and the upper metal mold 4-2 is divided into three partitions P1, P2 and P3 before the injection of resin. Here, the partition P1 is defined by the lower metal mold 4-1 and the island 23; the partition P2 is defined by the island 23 and the film 12 (and the semiconductor chip 13); and the partition P3 is defined by the film 12 (and the semiconductor chip) and the upper metal mold 4-2.

In the prior art resin molded semiconductor device, since a space or distance D1 between the lower metal mold 4-1 and the island 23 is remarkably larger than a space or distance D2 between the film 12 and the upper metal mold 4-2, for example, a ratio D1/D2 is 1.8, the amount of resin injected into the partition P1 is remarkably larger than the amount of resin injected into the partition P3 at an initial stage of injection of resin, as illustrated in Fig. 7. As a result, the island 23 with the semiconductor chip 13 mounted thereon may be moved up as indicated by an arrow X.

Also, in the prior art resin molded semiconductor device, since the island 23 is wider than the film 12, i.e., since the width D3 of the island 23 is larger than the width of the film 13, resin is hardly injected in the partition P2. Therefore, the amount of resin injected into the partition P3 is larger than the amount of resin injected into the partition P2 at an initial stage of injection of resin, as illustrated in Fig. 7. As a result, the film 12 may be moved down as indicated by an arrow Y.

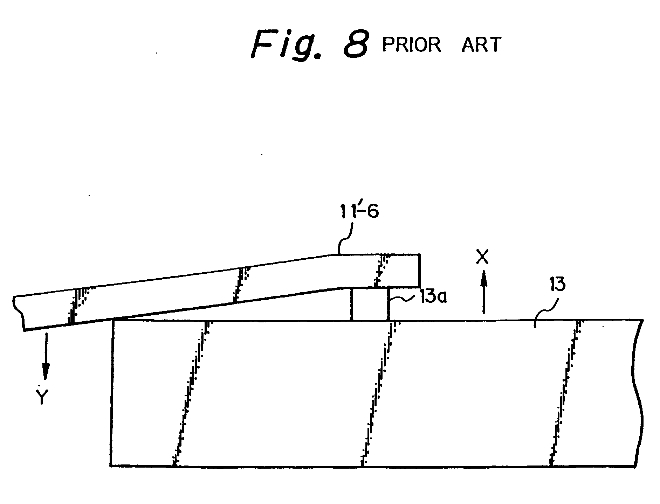

When the island 23 is moved up, or when the film 12 is moved down, an edge of the semiconductor chip 13 may be in contact with an inner portion of the internal lead such as 11'-6, as illustrated in Fig. 8. As a result, a short-circuit may occur between the semiconductor chip 13 and the internal leads. Also, the moving-up of the island 23 and the moving-down of the film 12 may break the injected resin, thus deteriorating the reliability thereof.

In the present invention, the moving-up of the island 23 and/or the moving-down of the film 12 are suppressed.

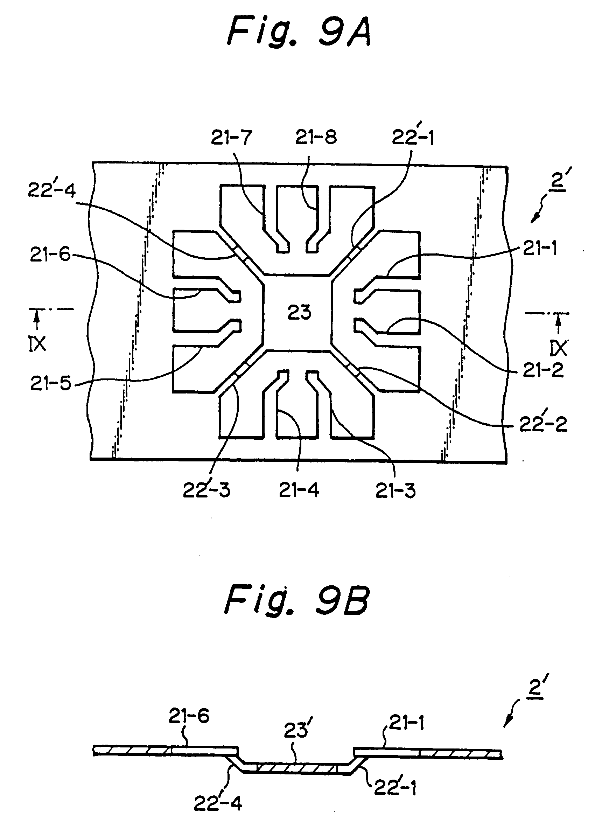

A first embodiment of the present invention will now be explained with reference to Figs. 9A, 9B, 10A, 10B, 11, 12 and 13.

In Figs. 9A and 9B, which correspond to Figs. 3A and 3B, respectively, a lead frame 2' has a narrower island 23' than the island 23 of Figs. 3A and 3B, and accordingly, has suspenders 22'-1, 22'-2, 22'-3 and 22'-4 longer than the suspenders 22-1, 22-2, 22-3 and 22-4 of Figs. 3A and 3B. In this case, the island 23' is narrower than the film 12 of the film carrier type semiconductor element 1 of Figs. 1A and 1B.

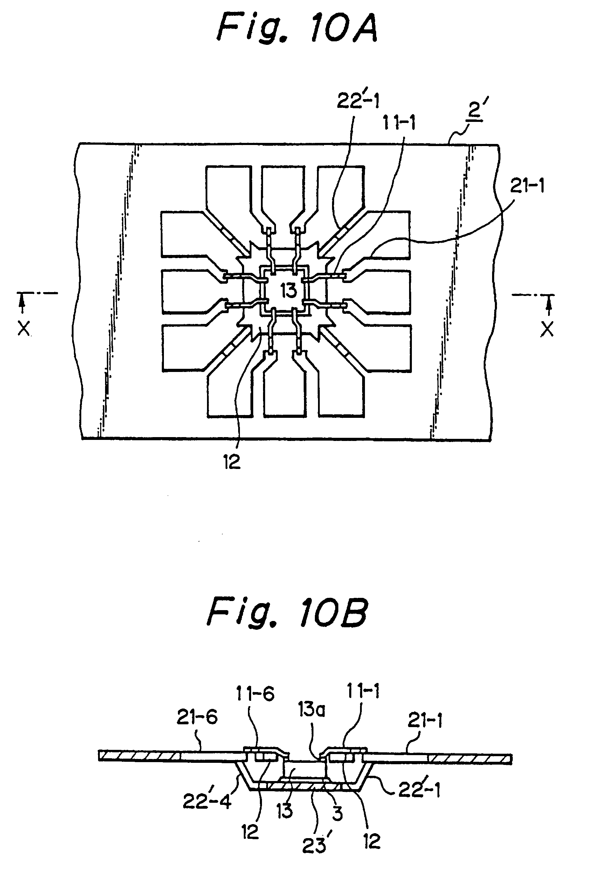

In Figs. 10A and 10B, which correspond to Figs. 4A and 4B, respectively, the film carrier type semiconductor element 1 of Figs. 1A and 1B is mounted on the lead frame 2' of Figs. 4A and 4B, thus completing a semiconductor assembly.

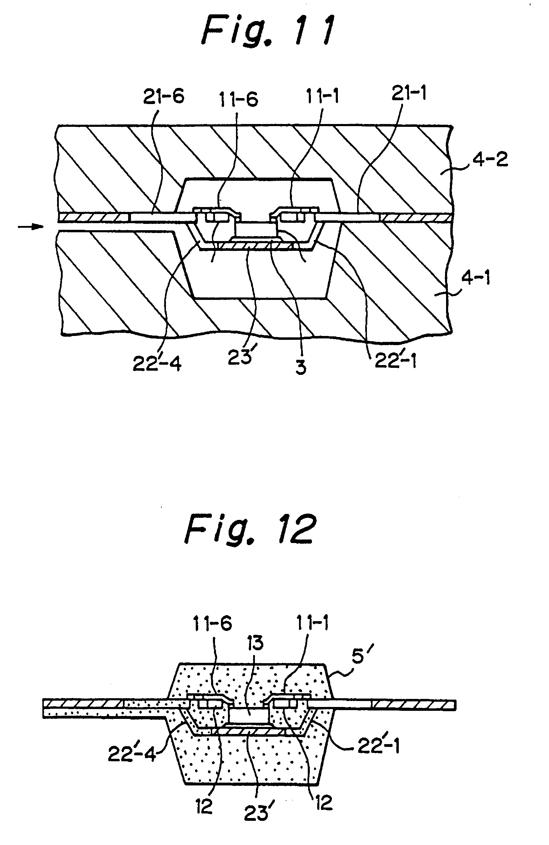

In Fig. 11, which corresponds to Fig. 5, the semiconductor device of Figs. 10A and 10B are sandwiched by the lower metal mold 4-1 and the upper metal mold 4-2, and hot resin is injected into a cavity between the lower metal mold 4-1 and the upper metal mold 4-2.

In Fig. 12, which corresponds to Fig. 6B, the lower metal mold 4-1 and the upper metal mold 4-2 are removed, and as a result, an enveloper 5' made of resin encapsulates the semiconductor assembly. Thus, a resin molded semiconductor device is completed.

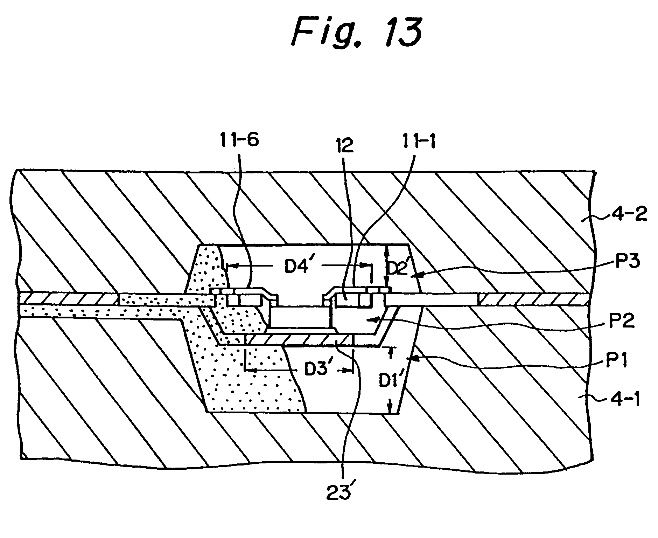

In Fig. 13, which explains an effect of the resin molded semiconductor device according to the first embodiment of the present invention, since a space or distance D1' between the lower metal mold 4-1 and the island 23' is only slightly larger than a space or distance D2' between the film 12 and the upper metal mold 4-2, for example, a ratio D1'/D2' is 1.1, the amount of resin injected into the partition P1 is slightly larger than the amount of resin injected into the partition P3 at an initial stage of injection of resin, as illustrated in Fig. 13. As a result, the island 23' having the semiconductor chip 13 mounted thereon is hardly moved up.

Also, since the island 23' is narrower than the film 12, i.e., since the width D3' of the island 23' is smaller than the width of the film 13, resin is smoothly injected into the partition P2. Therefore, the amount of resin injected into the partition P3 is not much larger than the amount of resin injected into the partition P2 at an initial stage of injection of resin, as illustrated in Fig. 13. As a result, the film 12 is hardly moved down.

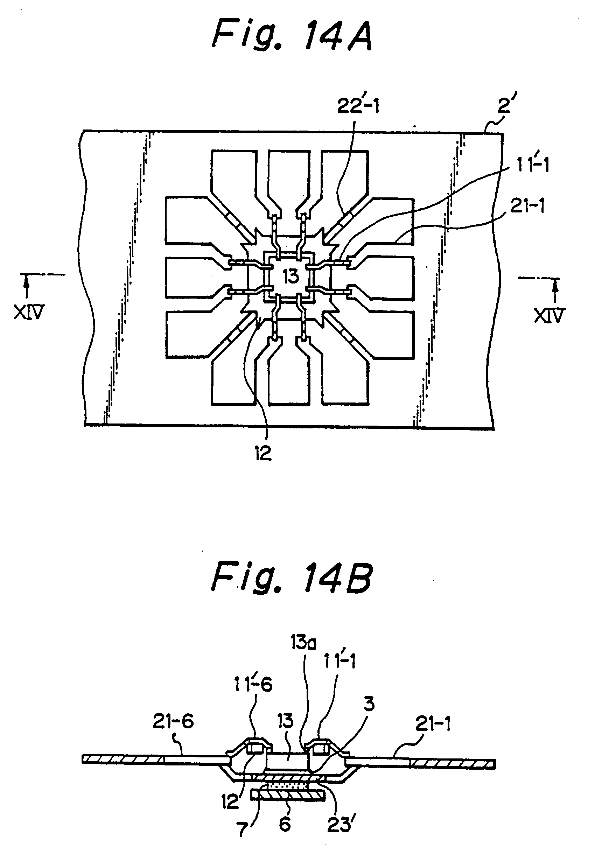

A second embodiment of the present invention will be explained with reference to Figs. 14A, 14B, 15, 16 and 17.

In Figs. 14A and 14B, which correspond to Figs. 10A and 10B, respectively, the film carrier type semiconductor element 1 of Figs. 2A and 2B is mounted on the lead frame 2' of Figs. 4A and 4B. In this case, a heat dissipation plate 6 is adhered by a polyimid member 7 to a rear face of the island 23'. Thus, a semiconductor assembly is completed.

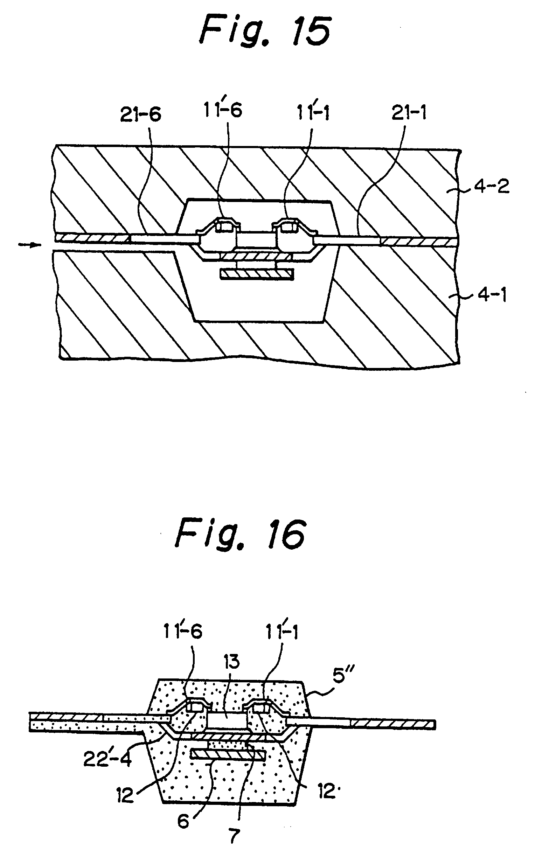

In Fig. 15, which corresponds to Fig. 11, the semiconductor device of Figs. 14A and 14B is sandwiched by the lower metal mold 4-1 and the upper metal mold 4-2, and hot resin is injected into a cavity between the lower metal mold 4-1 and the upper metal mold 4-2.

In Fig. 16, which corresponds to Fig. 12, the lower metal mold 4-1 and the upper metal mold 4-2 are removed, and as a result, an enveloper 5'' made of resin encapsulates the semiconductor device. Thus, a resin molded semiconductor device is completed.

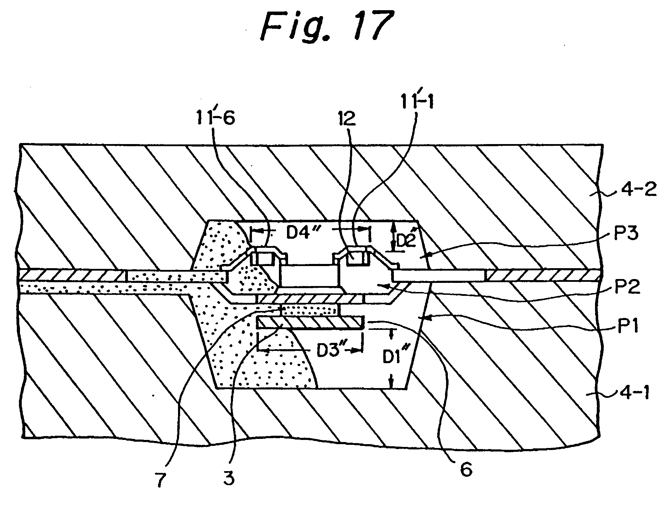

In Fig. 17, which explains an effect of the resin molded semiconductor device according to the second embodiment of the present invention, since a space or distance D1'' between the lower metal mold 4-1 and the heat dissipation member 6 is only slightly larger than a space or distance D2'' between the film 12 and the upper metal mold 4-2, for example, a ratio D1''/D2'' is 1.1, the amount of resin injected into the partition P1 is slightly larger than the amount of resin injected into the partition P3 at an initial stage of injection of resin, as illustrated in Fig. 17. As a result, the island 23' mounting the semiconductor chip 13 is hardly moved up.

Also, in this second embodiment since the island 23' is narrower than the film 12, i.e., since the width D3'' of the island 23' is smaller than the width of the film 13, resin is smoothly injected in the partition P2. Therefore, the amount of resin injected into the partition P3 is not much larger than the amount of resin injected into the partition P2 at an initial stage of injection of resin, as illustrated in Fig. 17. As a result, the film 12 is hardly moved down.

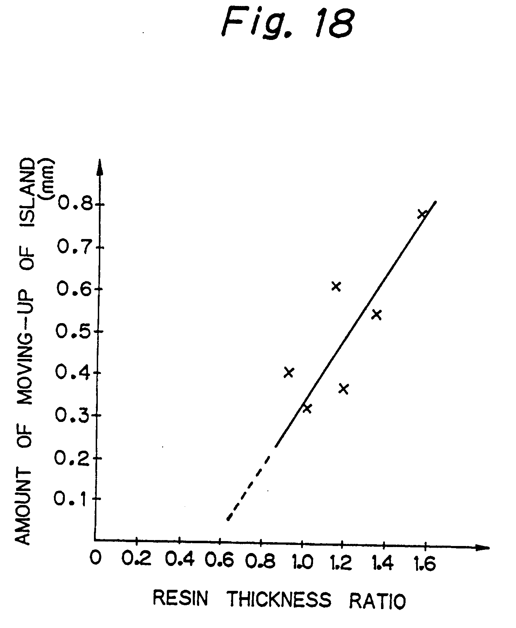

According to an experiment executed by the present inventor, as shown in Fig. 18, it was found that the amount of moving up of the island 23 (23') is dependent upon a resin thickness ratio defined by the space or distance D1 (D1', D1'') between the rear face of the island 23' (or the heat dissipation member 6) and the lower metal mold 4-1 to the space or distance D2 (D2', D2'') between the film 23 and the upper metal mold 4-2. For example, if the resin thickness ratio is less than 1.1, the amount of moving-up of the island 23' is less than 0.4mm. However, if the resin thickness ratio is larger than 1.6, the amount of moving-up of the island 23' is larger than 0.8mm, which may cause a short circuit between the semiconductor chip 13 and the inner portion of the internal leads, and also may deteriorate the reliability thereof. Note that it is actually impossible to make the resin thickness ratio less than 1.0 in view of design. Therefore, the resin thickness ratio is made 1.0 to 1.6, preferably, a value close to 1.0, such as 1.0 to 1.1.

Also, according to an experiment executed by the present inventor, if the ratio of the width D3 (D3', D3'') of the island 23 (23') to the width D4 (D4', D4'') of the film 12 is 1.108 or 1.160, the amount of moving-down of the film 12 is 0.54mm, and if the ratio of the width D3 (D3', D3'') of the island 23 (23') to the width D4 (D4', D4'') of the film 12 is 0.534, the amount of moving down of the film 12 is approximately 0mm (neglible).

As explained hereinbefore, according to the present invention, since the moving-up of the island and/or the moving-down of the film is suppressed, no short circuit can be generated between the semiconductor chip and the internal leads, and the reliability thereof can be improved.

## Claims

1. A resin molded semiconductor device comprising:
a film carrier type semiconductor element (1) including a film (12), a plurality of internal leads (11'-1, 11'-2, ...) adhered to said film, and a semiconductor chip (13) having a front face contacted to inner portions of said internal leads;
a lead frame (2) including an island (23') having a front face for supporting a rear face of said semiconductor chip and a plurality of external leads (21-1, 21-2, ...) each contacted to one outer portion of said internal leads; and
an enveloper (5') made of resin for encapsulating said film carrier type semiconductor element and a part of said external leads,
the thickness (D1') of said enveloper between the back face of said island and a back face of said enveloper being substantially the same as that (D2') of said enveloper between said film and a front face of said enveloper.

2. A device as set forth in claim 1, wherein the ratio of the thickness of said enveloper between the back face of said island and the back face of said enveloper to that of said enveloper between said film and the front face of said enveloper is 1.0∼1.6, preferably, 1.0∼1.1.

3. A device as set forth in claim 1, wherein the outer portions of said internal leads are horizontal.

4. A device as set forth in claim 1, wherein said island is narrower than said film.

5. A resin molded semiconductor device comprising:
a film carrier type semiconductor element (1) including a film (12), a plurality of internal leads ( 11-1, 11-2, ...) adhered to said film, and a semiconductor chip (13) having a front face contacted to inner portions of said internal leads;
a lead frame (2) including an island (23') having a front face for supporting a rear face of said semiconductor chip and a plurality of external leads (21-1, 21-2, ...) each contacted to one outer portion of said internal leads;
a heat dissipation member (6) adhered to the rear face of said island; and
an enveloper (5'') made of resin for encapsulating said film carrier type semiconductor element, a part of said external leads, and said heat dissipation member,
the thickness (D1'') of said enveloper between said heat dissipation member and a back face of said enveloper being substantially the same as that (D2'') of said enveloper between said film and a front face of said enveloper.

6. A device as set forth in claim 5, wherein the ratio of the thickness of said enveloper between said heat dissipation member and the back face of said enveloper to that of said enveloper between said film and the front face of said enveloper is 1.0∼1.6, preferably, 1.0∼1.1.

7. A device as set forth in claim 5, wherein said island is narrower than said film.

8. A resin molded semiconductor device comprising:
a film carrier type semiconductor element (1) including a film (12), a plurality of internal leads (11-1, 11-2, ..., 11'-1, 11'-2, ...) adhered to said film, and a semiconductor chip (13) having a front face contacted to inner portions of said internal leads;
a lead frame (2) including an island (23') having a front face for supporting a rear face of said semiconductor chip and a plurality of external leads (21-1, 21-2, ...) each contacted to one outer portion of said internal leads; and
an enveloper (5, 5', 5'') made of resin for encapsulating said film carrier type semiconductor element and a part of said external leads,
said island being narrower than said film.

9. A device as set forth in claim 8, further comprising a heat dissipation member (6) adhered to the rear face of said island,
said enveloper encapsulating said leat dissipation member.
